(19) Europäisches Patentamt
European Patent Office
Office européen des brevets

(11) EP 1 050 600 B1

(12) **EUROPEAN PATENT SPECIFICATION**

(45) Date of publication and mention
of the grant of the patent:
**19.07.2006 Bulletin 2006/29**

(51) Int Cl.:
*C23C 16/40* (2006.01)   *H01L 21/316* (2006.01)

(21) Application number: **99401092.4**

(22) Date of filing: **04.05.1999**

(54) **Thermal CVD process for depositing a low dielectric constant carbon-doped silicon oxide film**

Thermisches CVD Verfahren zur Erzeugung eines mit Kohlenstoff dotierten Siliziumoxidfilms mit niedriger dielektrischer Konstante

Procédé de formation par CVD thermique d'une couche en oxyde de silicium dopé au carbone et ayant une basse constante diélectrique

(84) Designated Contracting States:
**DE GB**

(43) Date of publication of application:
**08.11.2000 Bulletin 2000/45**

(73) Proprietor: **APPLIED MATERIALS, INC.
Santa Clara, California 95052 (US)**

(72) Inventors:
• **Xia, Li-Qun
San Jose,
California 95111 (US)**
• **Geiger, Fabrice
38240 Meylan (FR)**
• **Gaillard, Frédéric
38500 Voiron (FR)**
• **Yieh, Ellie
San Jose,
California 95138 (US)**
• **Lim, Tian
Santa Clara,
California 95051 (US)**

(74) Representative: **Kirschner, Klaus Dieter
advotec.
Böck, Tappe, Kirschner
Patent- und Rechtsanwälte
Sollner Strasse 38
81479 München (DE)**

(56) References cited:
**EP-A- 0 721 019**        **EP-A- 0 774 533**
**US-A- 5 872 065**

• **NARA A ET AL: "LOW DIELECTRIC CONSTANT INSULATOR BY DOWNSTREAM PLASMA CVD AT ROOM TEMPERATURE USING SI(CH3)4/O2" INTERNATIONAL CONFERENCE ON SOLID STATE DEVICES AND MATERIALS, vol. CONF. 1996, 1 January 1996 (1996-01-01), pages 815-817, XP000694126**
• **GUINN K V ET AL: "CHEMICAL VAPOR DEPOSITION OF SIO2 FROM OZONE-ORGANOSILANE MIXTURES NEAR ATMOSPHERIC PRESSURE" MATERIALS RESEARCH SOCIETY SYMPOSIUM PROCEEDINGS, vol. 282, 1 January 1993 (1993-01-01), pages 575-580, XP000575742 ISSN: 0272-9172**
• **SONG Y ET AL: "OPTICAL AND STRUCTURAL PROPERTIES OF LOW-TEMPERATURE PECVD ETMS SIOX THIN FILMS" THIN SOLID FILMS, vol. 334, no. 1/02, 4 December 1998 (1998-12-04), pages 92-97, XP000669262 ISSN: 0040-6090**

EP 1 050 600 B1

**Description**

BACKGROUND OF THE INVENTION

The present invention relates to the formation of dielectric layers during fabrication of integrated circuits on semiconductor wafers. More particularly, the present invention relates to a method for providing a dielectric film having a low dielectric constant that is particularly useful as a premetal or intermetal dielectric layer.

One of the primary steps in the fabrication of modern semiconductor devices is the formation of a thin film on a semiconductor substrate by chemical reaction of gases. Such a deposition process is referred to as chemical vapor deposition or "CVD." Conventional thermal CVD processes supply reactive gases to the substrate surface where heat-induced chemical reactions take place to produce a desired film. Plasma enhanced CVD techniques, on the other hand, promote excitation and/or dissociation of the reactant gases by the application of radio frequency (RF) or microwave energy. The high reactivity of the released species reduces the energy required for a chemical reaction to take place, and thus lowers the required temperature for such PECVD processes.

Semiconductor device geometries have dramatically decreased in size since such devices were first introduced several decades ago. Today's fabrication plants are routinely producing devices having 0.25 $\mu$m and even 0.18$\mu$m feature sizes, and tomorrow's plants soon will be producing devices having even smaller geometries. In order to further reduce the size of devices on integrated circuits, it has become necessary to use conductive materials having low resistivity and insulators having a low dielectric constant. Low dielectric constant films are particularly desirable for premetal dielectric (PMD) layers and intermetal dielectric (IMD) layers to reduce the RC time delay of the interconnect metalization, to prevent cross-talk between the different levels of metalization, and to reduce device power consumption.

Undoped silicon oxide films deposited using conventional CVD techniques may have a dielectric constant (k) as low as about 4.0 or 4.2. One approach to obtaining a lower dielectric constant is to incorporate fluorine in the silicon oxide film. Fluorine-doped silicon oxide films (also referred to as fluorine silicate glass or - "FSG" films) may have a dielectric constant as low as about 3.4 or 3.6. Despite this improvement, films having even lower dielectric constants are highly desirable for the manufacture of integrated circuits using geometries of 0.18$\mu$m and smaller. Numerous films have been developed in attempts to meet these needs including: a spin-on glass called HSQ (hydrogen silsesqui-oxane, $HSiO_{1.5}$) and various carbon-based dielectric layers, such as parylene and amorphous fluorinated carbon. While the above types of dielectric films are useful for some applications, manufacturers are always seeking new and improved methods of depositing low-k materials for use as IMD and other types of dielectric layers.

The document: Guinn K.V. et al.: "Chemical vapor deposition of $SiO_2$ from ozone-organosilane mixtures near atmospheric pressure", Material Research Society Symposium Proceedings, vol. 282, January 01, 1993, pages 575-580, XP 000575742, ISSN: 0272-9172 studies the kinetics of deposition of $SiO_2$ by the reaction of tetramethylsilane (TMS) with ozone ($O_3$) over the temperature range 180-380°C and compares them with available data for the same process using tetraethoxysilane (TEOS). Both processes exhibit the same activation energy (17 kcal/mole) below 300°C which falls-off at higher temperatures due to transport limitations. Transition from first- to zero-order kinetics occurs with increasing concentrations of TMS and $O_3$, which gives an overall $O_3$/TMS consumption ratio of 10 at 258°C and 5 at 325°C. TEOS is estimated to be 5 times more reactive than TMS above 300°C and over 10 times more reactive in the kinetically-limited regime below 300°C. Results suggest that $O_3$-induced $SiO_2$ deposition proceeds via surface reactions and is limited by heterogeneous decomposition of ozone.

From the EP 0 774 533 A1 a method for depositing Si-O-containing coatings in known. Coatings containing silicon and oxygen are formed by the chemical vapor deposition of a reactive gas mixture comprising an organosilicon material selected from dimethylsilane and trimethylsilane and an oxygen source. The process comprises introducing the reactive gas mixture into a deposition chamber containing the substrate to be coated and then inducing reaction to form the coating.

The EP 0 721 019 A2 describes a process for very low temperature chemical vapor deposition of silicon dioxide, comprising the steps of heating a substrate upon which silicon dioxide is to be deposited to a temperature in the range of approximately 150 to 500°C in a vacuum maintained at a pressure in the range of approximately 50 to 750 mTorr; introducing into the vacuum an organosilane containing feed and an oxygen containing feed, the organosilane feed consisting essentially of one or more compounds having a specific general formula given in the EP 0 721 019 A2; and maintaining the temperature and the vacuum thereby causing a thin film of silicon dioxide to deposit on the substrate.

SUMMARY OF THE INVENTION

The method of the present invention provides such a new and improved low-k material deposition process. The process is particularly useful in the manufacture of sub-0.2 micron circuits as it can form a PMD or IMD film with a dielectric constant below 3.0. The film has good gap fill capabilities, high film stability and etches uniformly and controllably when subject to a chemical mechanical polishing (CMP) step.

The method of the present invention deposits a carbon-doped silicon oxide layer using a thermal, as opposed to plasma, CVD process. The layer is deposited from a process gas of ozone and an organosilane precursor having at least one silicon-carbon (Si-C) bond. During the deposition process, the substrate is heated to a temperature less than about 250°C.

In some currently preferred embodiments the organosilane precursor has a formula of $Si(CH_3)_xH_{4-x}$ where x is either 3 or 4 making the organosilane precursor either trimethylsilane (TMS) or tetramethylsilane (T4MS). In other preferred embodiments, the substrate over which the carbon-doped oxide layer is deposited is heated to a temperature of between about 150-200°C and the deposition is carried out in a vacuum chamber at a pressure of between 1-760 Torr. In still other preferred embodiments, the carbon-doped silicon oxide layer is cured after it is deposited to minimize subsequent moisture absorbtion. Curing can be done in either a vacuum or conventional furnace environment.

In one specific embodiment, the process gas is a mixture of TMS, ozone and helium. Deposition pressure in this embodiment can be any pressure between 1 - 760 Torr, but the flow rate of the TMS source is selected so that the partial pressure of TMS is less than its vapor pressure in the deposition environment. In a preferred version of this embodiment, after film deposition is substantially completed, the ozone flow into the deposition chamber is stopped at least several seconds prior to the flow of TMS in order to ensure that residual ozone in the chamber reacts, in the gas phase, with the TMS and not with carbon in the deposited film.

These and other embodiments of the present invention, as well as its advantages and features, are described in more detail in conjunction with the text below and attached figures.

BRIEF DESCRIPTION OF THE DRAWINGS

Figs. 1A and 1B are vertical, cross-sectional views of one embodiment of a chemical vapor deposition apparatus according to the present invention;

Figs. 1C and 1D are exploded perspective views of parts of the CVD chamber depicted in Fig. 1A;

Fig. 1E is a simplified diagram of system monitor and CVD system 10 in a multi-chamber system, which may include one or more chambers;

Fig. 2 shows an illustrative block diagram of the hierarchical control structure of the system control software, computer program 70, according to a specific embodiment;

Fig. 3 is a flowchart illustrating the formation of a carbon-doped silicon oxide layer according to one embodiment of the method of the present invention;

Fig. 4 is a graph of substrate temperature versus dielectric constant for a carbon-doped silicon oxide film deposited in accordance with a particular embodiment of the present invention;

Fig. 5 is a graph showing the effect of substrate temperature on deposition rate for a carbon-doped silicon oxide film deposited in accordance with a particular embodiment of the present invention;

Figs. 6A-C are drawings illustrating the gap fill capabilities of films deposited according to the present invention at deposition temperatures of 150-250 °C;

Fig. 7 is a graph showing the effect of an inert gas flow of helium on film uniformity in a carbon-doped silicon oxide film deposited according to the present invention;

Figs. 8A and 8B are graphs of FTIR data that compare the crystalline orientation of a carbon-doped silicon oxide film deposited and cured according to the present invention with an uncured film; and

Fig. 9 is a flowchart of a currently preferred process according to the present invention that employs a process gas of TMS, ozone and helium.

DESCRIPTION OF THE SPECIFIC EMBODIMENTS

**I. Exemplary CVD System**

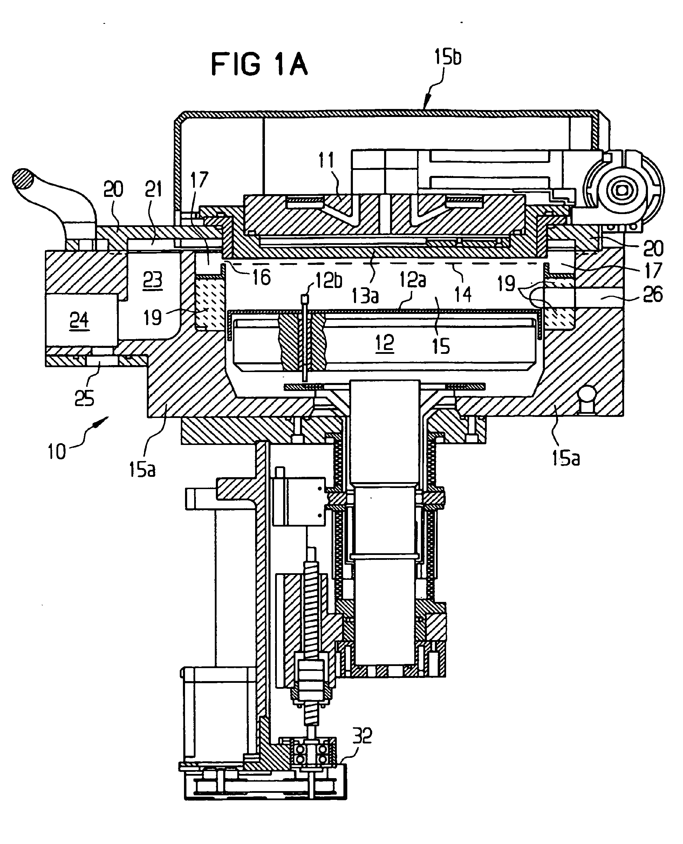

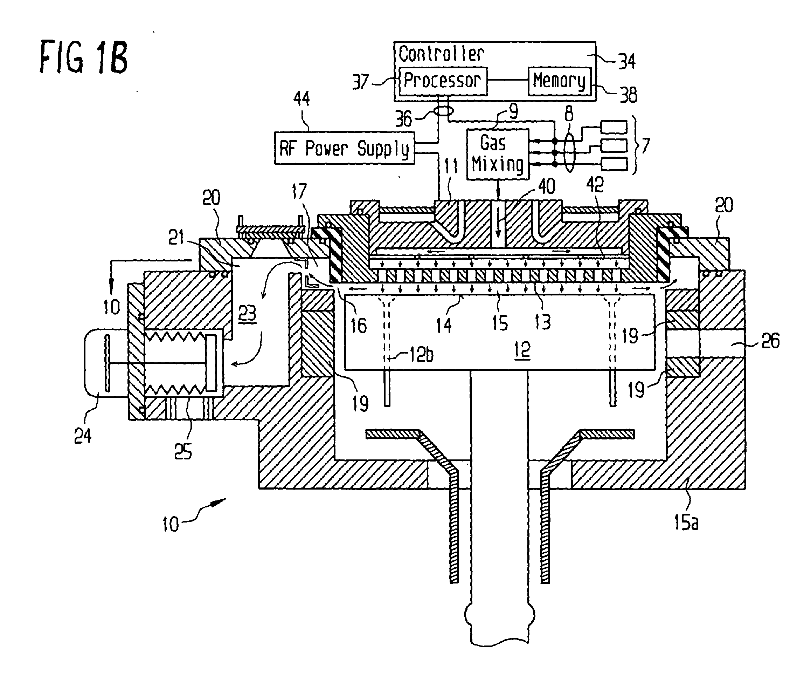

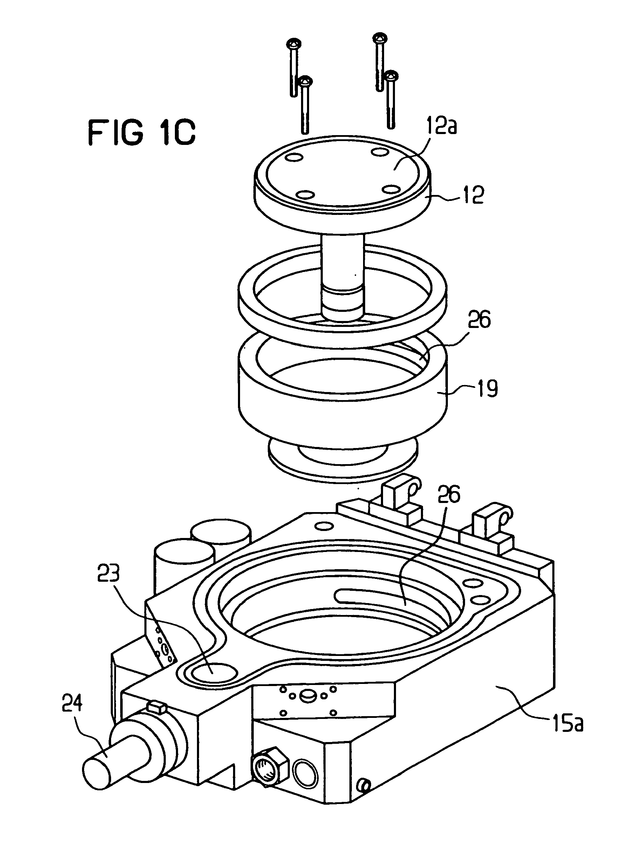

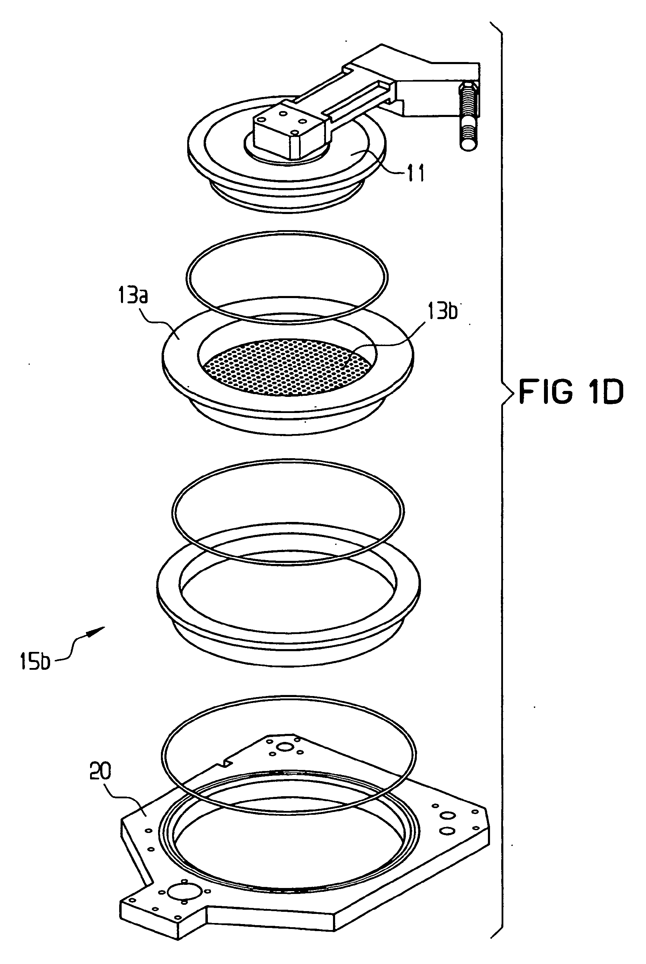

One suitable CVD apparatus in which the method of the present invention can be carried out is shown in Figs. 1A and 1B, which are vertical, cross-sectional views of a CVD system 10, having a vacuum or processing chamber 15 that includes a chamber wall 15a and chamber lid assembly 15b. Chamber wall 15a and chamber lid assembly 15b are shown in exploded, perspective views in Figs. 1C and 1D.

CVD system 10 contains a gas distribution manifold 11 for dispersing process gases to a substrate (not shown) that rests on a heated pedestal 12 centered within the process chamber. During processing, the substrate (e.g. a semiconductor wafer) is positioned on a flat (or slightly convex) surface 12a of pedestal 12. The pedestal can be moved controllably between a lower loading/off-loading position (depicted in Fig. 1A) and an upper processing position (indicated by dashed line 14 in Fig. 1A and shown in Fig. 1B), which is closely adjacent to manifold 11. A centerboard (not shown) includes sensors for providing information on the position of the wafers.

Deposition and carrier gases are introduced into chamber 15 through perforated holes 13b (Fig. 1D) of a conventional flat, circular gas distribution or faceplate 13a. More specifically, deposition process gases flow into the chamber through the inlet manifold 11 (indicated by arrow 40 in Fig. 1B), through a conventional perforated blocker plate 42 and then through holes 13b in gas distribution faceplate 13a.

Before reaching the manifold, deposition and carrier gases are input from gas sources 7 through gas supply lines 8 (Fig. 1B) into a mixing system 9 where they are combined and then sent to manifold 11. Generally, the supply line for each process gas includes (i) several safety shut-off valves (not shown) that can be used to automatically or manually shut-off the flow of process gas into the chamber, and (ii) mass flow controllers (also not shown) that measure the flow of gas through the supply line. When toxic gases are used in the process, the several safety shut-off valves are positioned on each gas supply line in conventional configurations.

The deposition process performed in CVD system 10 can be either a thermal process or a plasma-enhanced process. In a plasma-enhanced process, an RF power supply 44 applies electrical power between the gas distribution faceplate 13a and the pedestal so as to excite the process gas mixture to form a plasma within the cylindrical region between the faceplate 13a and the pedestal. (This region will be referred to herein as the "reaction region"). Constituents of the plasma react to deposit a desired film on the surface of the semiconductor wafer supported on pedestal 12. RF power supply 44 is a mixed frequency RF power supply that typically supplies power at a high RF frequency (RF1) of 13.56 MHz and at a low RF frequency (RF2) of 360 KHz to enhance the decomposition of reactive species introduced into the vacuum chamber 15. In a thermal process, RF power supply 44 would not be utilized, and the process gas mixture thermally reacts to deposit the desired films on the surface of the semiconductor wafer supported on pedestal 12, which is resistively heated to provide thermal energy for the reaction.

During a plasma-enhanced deposition process, the plasma heats the entire process chamber 10, including the walls of the chamber body 15a surrounding the exhaust passageway 23 and the shut-off valve 24. When the plasma is not turned on or during a thermal deposition process, a hot liquid is circulated through the walls 15a of the process chamber to maintain the chamber at an elevated temperature. A portion of these heat exchanging passages in the lid of chamber 10 (passages 18) is shown in Fig. 1B. The passages in the remainder of chamber walls 15a are not shown. Fluids used to heat the chamber walls 15a include the typical fluid types, i.e., water-based ethylene glycol or oil-based thermal transfer fluids. This heating (referred to as heating by the "heat exchanger") beneficially reduces or eliminates condensation of undesirable reactant products and improves the elimination of volatile products of the process gases and other contaminants that might contaminate the process if they were to condense on the walls of cool vacuum passages and migrate back into the processing chamber during periods of no gas flow.

The remainder of the gas mixture that is not deposited in a layer, including reaction byproducts, is evacuated from the chamber by a vacuum pump (not shown). Specifically, the gases are exhausted through an annular, slot-shaped orifice 16 surrounding the reaction region and into an annular exhaust plenum 17. The annular slot 16 and the plenum 17 are defined by the gap between the top of the chamber's cylindrical side wall 15a (including the upper dielectric lining 19 on the wall) and the bottom of the circular chamber lid 20. The 360° circular symmetry and uniformity of the slot orifice 16 and the plenum 17 are important to achieving a uniform flow of process gases over the wafer so as to deposit a uniform film on the wafer.

From the exhaust plenum 17, the gases flow underneath a lateral extension portion 21 of the exhaust plenum 17, past a viewing port (not shown), through a downward-extending gas passage 23, past a vacuum shut-off valve 24 (whose body is integrated with the lower chamber wall 15a), and into the exhaust outlet 25 that connects to the external vacuum pump (not shown) through a foreline (also not shown).

The wafer support platter of the pedestal 12 (preferably aluminum, ceramic, or a combination thereof) is resistively-heated using an embedded single-loop embedded heater element configured to make two full turns in the form of parallel concentric circles. An outer portion of the heater element runs adjacent to a perimeter of the support platter, while an inner portion runs on the path of a concentric circle having a smaller radius. The wiring to the heater element passes through the stem of the pedestal 12.

Typically, any or all of the chamber lining, gas inlet manifold faceplate, and various other reactor hardware are made out of material such as aluminum, anodized aluminum, or ceramic. An example of such a CVD apparatus is described in U.S. Patent 5,558,717 entitled "CVD Processing Chamber," issued to Zhao *et al.* The 5,558,717 patent is assigned to Applied Materials, Inc., the assignee of the present invention, and is hereby incorporated by reference in its entirety.

A lift mechanism and motor 32 (Fig. 1A) raises and lowers the heater pedestal assembly 12 and its wafer lift pins 12b as wafers are transferred into and out of the body of the chamber by a robot blade (not shown) through an insertion/removal opening 26 in the side of the chamber 10. The motor 32 raises and lowers pedestal 12 between a processing position 14 and a lower, wafer-loading position. The motor, valves or flow controllers connected to the supply lines 8, gas delivery system, throttle valve, RF power supply 44, and chamber and substrate heating systems are all controlled by a system controller 34 (Fig. 1B) over control lines 36, of which only some are shown. Controller 34 relies on feedback from optical sensors to determine the position of movable mechanical assemblies such as the throttle valve and susceptor which are moved by appropriate motors under the control of controller 34.

In a preferred embodiment, the system controller includes a hard disk drive (memory 38), a floppy disk drive and a processor 37. The processor contains a single-board computer (SBC), analog and digital input/output boards, interface boards and stepper motor controller boards. Various parts of CVD system 10 conform to the Versa Modular European (VME) standard which defines board, card cage, and connector dimensions and types. The VME standard also defines the bus structure as having a 16-bit data bus and a 24-bit address bus.

System controller 34 controls all of the activities of the CVD machine. The system controller executes system control software, which is a computer program stored in a computer-readable medium such as a memory 38. Preferably, memory 38 is a hard disk drive, but memory 38 may also be other kinds of memory. The computer program includes sets of instructions that dictate the timing, mixture of gases, chamber pressure, chamber temperature, RF power levels, susceptor position, and other parameters of a particular process. Other computer programs stored on other memory devices including, for example, a floppy disk or other another appropriate drive, may also be used to operate controller 34.

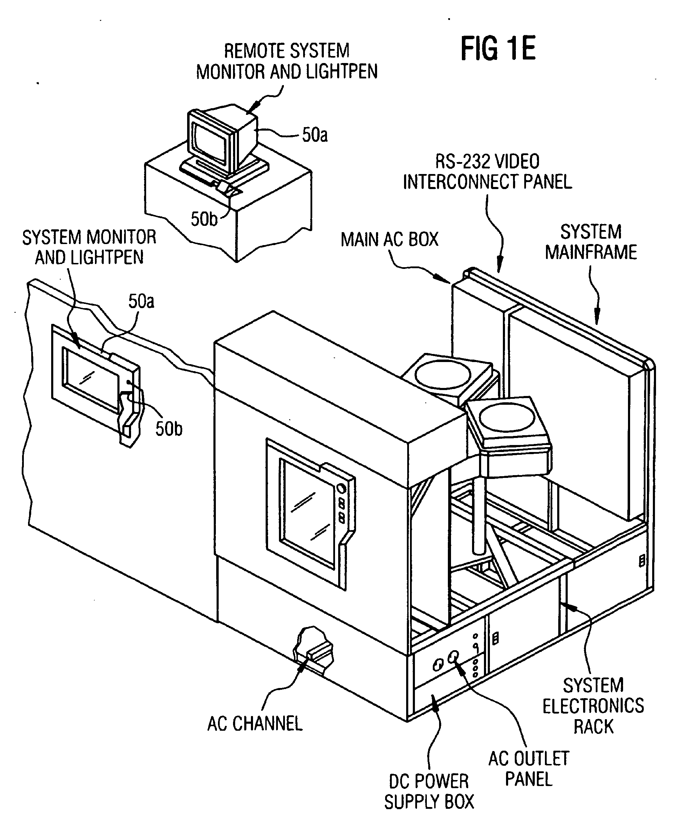

The interface between a user and controller 34 is via a CRT monitor 50a and light pen 50b, shown in Fig. 1E, which is a simplified diagram of the system monitor and CVD system 10 in a substrate processing system, which may include one or more chambers. In the preferred embodiment two monitors 50a are used, one mounted in the clean room wall for the operators and the other behind the wall for the service technicians. The monitors 50a simultaneously display the same information, but only one light pen 50b is enabled. A light sensor in the tip of light pen 50b detects light emitted by CRT display. To select a particular screen or function, the operator touches a designated area of the display screen and pushes the button on the pen 50b. The touched area changes its highlighted color, or a new menu or screen is displayed, confirming communication between the light pen and the display screen. Other devices, such as a keyboard, mouse, or other pointing or communication device, may be used instead of or in addition to light pen 50b to allow the user to communicate with controller 34.

The process for depositing the film can be implemented using a computer program product that is executed by controller 34. The computer program code can be written in any conventional computer readable programming language: for example, 68000 assembly language, C, C++, Pascal, Fortran or others. Suitable program code is entered into a single file, or multiple files, using a conventional text editor, and stored or embodied in a computer usable medium, such as a memory system of the computer. If the entered code text is in a high level language, the code is compiled, and the resultant compiler code is then linked with an object code of precompiled Windows™ library routines. To execute the linked, compiled object code the system user invokes the object code, causing the computer system to load the code in memory. The CPU then reads and executes the code to perform the tasks identified in the program.

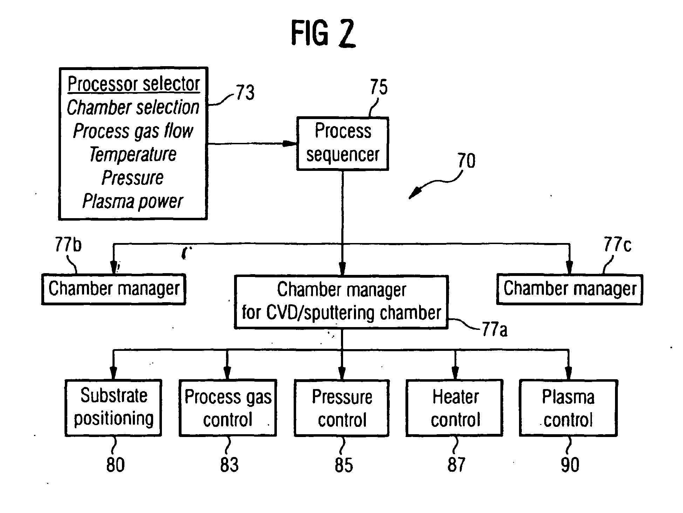

Fig. 2 is an illustrative block diagram of the hierarchical control structure of the system control software, computer program 70, according to a specific embodiment. Using the light pen interface, a user enters a process set number and process chamber number into a process selector subroutine 73 in response to menus or screens displayed on the CRT monitor. The process sets are predetermined sets of process parameters necessary to carry out specified processes, and are identified by predefined set numbers. The process selector subroutine 73 identifies (i) the desired process chamber and (ii) the desired set of process parameters needed to operate the process chamber for performing the desired process. The process parameters for performing a specific process relate to process conditions such as, for example, process gas composition and flow rates, temperature, pressure, plasma conditions such as RF power levels and the low frequency RF frequency, cooling gas pressure, and chamber wall temperature. These parameters are provided to the user in the form of a recipe, and are entered utilizing the light pen/CRT monitor interface.

The signals for monitoring the process are provided by the analog and digital input boards of the system controller, and the signals for controlling the process are output on the analog and digital output boards of CVD system 10.

A process sequencer subroutine 75 comprises program code for accepting the identified process chamber and set of process parameters from the process selector subroutine 73, and for controlling operation of the various process chambers. Multiple users can enter process set numbers and process chamber numbers, or a user can enter multiple process set numbers and process chamber numbers, so the sequencer subroutine 75 operates to schedule the selected processes in the desired sequence. Preferably, the sequencer subroutine 75 includes a program code to perform the steps of (i) monitoring the operation of the process chambers to determine if the chambers are being used, (ii) determining what processes are being carried out in the chambers being used, and (iii) executing the desired process based on availability of a process chamber and type of process to be carried out. Conventional methods of monitoring the process chambers can be used, such as polling. When scheduling which process is to be executed, sequencer subroutine 75 takes into consideration the present condition of the process chamber being used in comparison with the desired process conditions for a selected process, or the "age" of each particular user entered request, or any other relevant factor a system programmer desires to include for determining scheduling priorities.

Once the sequencer subroutine 75 determines which process chamber and process set combination is going to be executed next, the sequencer subroutine 75 initiates execution of the process set by passing the particular process set parameters to a chamber manager subroutine 77a-c, which controls multiple processing tasks in a process chamber 15 according to the process set determined by the sequencer subroutine 75. For example, the chamber manager subroutine 77a comprises program code for controlling sputtering and CVD process operations in the process chamber 15. The chamber manager subroutine 77 also controls execution of various chamber component subroutines that control operation of the chamber components necessary to carry out the selected process set. Examples of chamber component subroutines are substrate positioning subroutine 80, process gas control subroutine 83, pressure control subroutine 85, heater control subroutine 87, and plasma control subroutine 90. Those having ordinary skill in the art will readily recognize that other chamber control subroutines can be included depending on what processes are to be performed in the process chamber 15. In operation, the chamber manager subroutine 77a selectively schedules or calls the process component subroutines in accordance with the particular process set being executed. The chamber manager subroutine 77a schedules the process component subroutines much like the sequencer subroutine 75 schedules which process chamber 15 and process set are to be executed next. Typically, the chamber manager subroutine 77a includes steps of monitoring the various chamber components, determining which components need to be operated based on the process parameters for the process set to be executed, and causing execution of a chamber component subroutine responsive to the monitoring and determining steps.

Operation of particular chamber component subroutines will now be described with reference to Fig. 2. The substrate positioning subroutine 80 comprises program code for controlling chamber components that are used to load the substrate onto pedestal 12 and, optionally, to lift the substrate to a desired height in the chamber 15 to control the spacing between the substrate and the gas distribution manifold 11. When a substrate is loaded into the process chamber 15, pedestal 12 is lowered to receive the substrate, and thereafter, the susceptor 12 is raised to the desired height in the chamber, to maintain the substrate at a first distance or spacing from the gas distribution manifold during the CVD process. In operation, the substrate positioning subroutine 80 controls movement of pedestal 12 in response to process set parameters related to the support height that are transferred from the chamber manager subroutine 77a.

The process gas control subroutine 83 has program code for controlling process gas composition and flow rates. The process gas control subroutine 83 controls the open/close position of the safety shut-off valves, and also ramps up/down the mass flow controllers to obtain the desired gas flow rate. The process gas control subroutine 83 is invoked by the chamber manager subroutine 77a, as are all chamber component subroutines, and receives from the chamber manager subroutine process parameters related to the desired gas flow rates. Typically, the process gas control subroutine 83 operates by opening the gas supply lines and repeatedly (i) reading the necessary mass flow controllers, (ii) comparing the readings to the desired flow rates received from the chamber manager subroutine 77a, and (iii) adjusting the flow rates of the gas supply lines as necessary. Furthermore, the process gas control subroutine 83 includes steps for monitoring the gas flow rates for unsafe rates and for activating the safety shut-off valves when an unsafe condition is detected.

In some processes, an inert gas such as helium or argon is flowed into the chamber 15 to stabilize the pressure in the chamber before reactive process gases are introduced. For these processes, the process gas control subroutine 83 is programmed to include steps for flowing the inert gas into the chamber 15 for an amount of time necessary to stabilize the pressure in the chamber, and then the steps described above would be carried out. Additionally, when a process gas is to be vaporized from a liquid precursor, for example, tetraethylorthosilane ("TEOS"), the process gas control subroutine 83 is written to include steps for bubbling a delivery gas, such as helium, through the liquid precursor in a bubbler assembly or introducing a carrier gas, such as helium or nitrogen, to a liquid injection system.

The pressure control subroutine 85 comprises program code for controlling the pressure in the chamber 15 by regulating the size of the opening of the throttle valve in the exhaust system of the chamber. The size of the opening of the throttle valve is set to control the chamber pressure to the desired level in relation to the total process gas flow, size of the process chamber, and pumping setpoint pressure for the exhaust system. When the pressure control subroutine 85 is invoked, the desired, or target, pressure level is received as a parameter from the chamber manager subroutine 77a. The pressure control subroutine 85 operates to measure the pressure in the chamber 15 by reading one or more conventional pressure manometers connected to the chamber, to compare the measure value(s) to the target pressure, to obtain PID (proportional, integral, and differential) values from a stored pressure table corresponding to the target pressure, and to adjust the throttle valve according to the PID values obtained from the pressure table. Alternatively, the pressure control subroutine 85 can be written to open or close the throttle valve to a particular opening size to regulate the chamber 15 to the desired pressure.

The heater control subroutine 87 comprises program code for controlling the current to a heating unit that is used to heat the substrate 20. The heater control subroutine 87 is also invoked by the chamber manager subroutine 77a and receives a target, or set-point, temperature parameter. The heater control subroutine 87 measures the temperature by measuring voltage output of a thermocouple located in pedestal 12, comparing the measured temperature to the set-point temperature, and increasing or decreasing current applied to the heating unit to obtain the set-point temperature. The temperature is obtained from the measured voltage by looking up the corresponding temperature in a stored conversion table, or by calculating the temperature using a fourth-order polynomial. When an embedded loop is used to heat pedestal 12, the heater control subroutine 87 gradually controls a ramp up/down of current applied to the loop. Additionally, a built-in fail-safe mode can be included to detect process safety compliance, and can shut down operation of the heating unit if the process chamber 15 is not properly set up.

The plasma control subroutine 90 comprises program code for setting the low and high frequency RF power levels applied to the process electrodes in the chamber 15 and for setting the low frequency RF frequency employed. Similar to the previously described chamber component subroutines, the plasma control subroutine 90 is invoked by the chamber manager subroutine 77a.

The above reactor description is mainly for illustrative purposes, and other thermal CVD equipment such as the Giga-fill chamber manufactured by Applied Materials may be employed. Additionally, variations of the above-described system, such as variations in pedestal design, heater design, RF power frequencies, location of RF power connections and others are possible. For example, the wafer could be supported by a susceptor and heated by quartz lamps. The layer and method for forming such a layer of the present invention is not limited to any specific apparatus or to any specific plasma excitation method.

## II. Deposition of a Low Dielectric Constant IMD Layer

The present invention forms a stable, low dielectric constant insulation film using a CVD deposition chamber such as the exemplary chamber described above. The process deposits a carbon-doped silicon oxide film that is particularly useful for the deposition of premetal and intermetal dielectric layers (sometimes referred to as interlevel dielectric layers), especially those used for sub-0.2 micron applications.

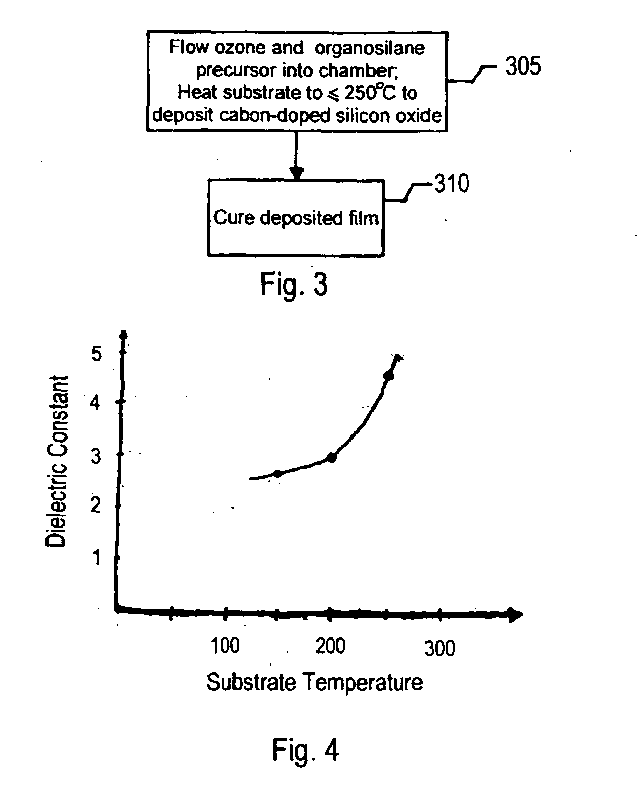

Fig. 3 is a flowchart illustrating the formation of a carbon-doped silicon oxide layer according to the method of the present invention. As shown in Fig. 3, the film is deposited by flowing an organosilane precursor gas and ozone into a substrate processing chamber and heating the substrate within the chamber to a temperature less than about 250°C (step 305). The deposition process is a thermal, as opposed to plasma, CVD process. After the film is deposited, it is then cured (step 310) to increase its resistance to moisture absorbtion. In order to form a film having a sufficiently low dielectric constant, it is important that the organosilane precursor gas used for film deposition have at least one silicon-carbon bond. Examples of such precursor gases include methylsilane, dimethylsilane (DMS), trimethylsilane (TMS), tetramethylsilane (T4MS) and phenylmethylsilane among others. Because of their commercial availability and high number of silicon-carbon bonds, TMS and T4MS are the currently most preferred precursor gases. Further details of the preferred deposition process conditions and preferred curing processes are discussed in detail below.

The present inventors have found that the dielectric constant of carbon-doped silicon oxide film deposited in step 305 is directly related to the temperature of the substrate during deposition. In order to deposit a film having a dielectric constant that is sufficient for low k applications (e.g., a k less than or equal to 3.0), it is important that the deposition temperature be kept below 250°C. Temperatures lower than 250°C are preferred in other embodiments.

As used herein "deposition temperature" refers to the temperature of the substrate during deposition. In the currently preferred embodiments, the substrate is directly heated by the pedestal heater. At higher pressures, e.g., 200 Torr and above, the substrate temperature is practically equal to the pedestal temperature (substrate temperature may be about 10°C less) due to conduction and convection heating. At near vacuum pressures, however, (e.g., less than 50 Torr) there may be a 50-60°C temperature difference between the substrate and pedestal because of the lack of convection heating. Thus, at these lower pressure levels, the pedestal temperature can be set up to 50-60°C higher than the desired deposition temperature.

Fig. 4 is a graph showing the effect of temperature on dielectric constant for a particular set of deposition conditions at a deposition pressure above 200 Torr. As shown in Fig. 4, a pedestal temperature of 250°C resulted in a dielectric constant of 4.6 while pedestal temperatures of 200°C and 150°C resulted in dielectric constants of 3.0 and 2.7 respectively. Thus, as evident from the figure and from other tests the inventors ran, a temperature of 200°C and below is preferred. It is believed that the deposition temperature has a direct effect on the amount of carbon incorporated into the deposited film. Silicon oxide films having higher carbon concentration levels generally have a lower dielectric constant than silicon oxide films having lower carbon levels, other dopant concentrations being similar. Films deposited according to the present invention preferably have a carbon content of at least 8 atomic percent and more preferably at least 10 atomic percent.

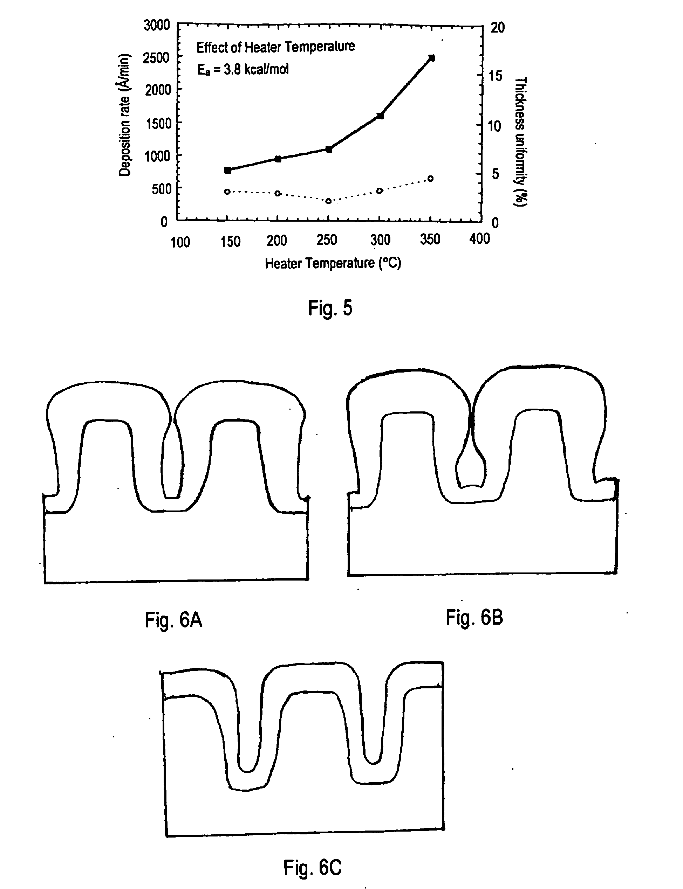

Deposition temperature is also important, however, in achieving gas phase reactions between ozone and the organosilane precursor. Ozone activates through these gas phase collisions and a sufficiently high temperature is required to ensure a commercially acceptable deposition rate. Thus, while it is important to have a sufficiently low deposition temperature to obtain an appropriate low dielectric constant, this must be balanced against deposition rate. Fig. 5 is a graph showing the effect of pedestal temperature on deposition rate. For Fig. 5 a carbon-doped silicon oxide film was deposited at a pressure of 200 Torr and spaced 250 mils from the gas distribution manifold. A process gas of TMS (500 sccm), 12.5 wt. % ozone (1000 sccm and helium (6000 sccm) was flowed into the chamber and the pedestal temperature was varied from 150°C to 350°C. As shown in Fig. 5, deposition rate increases as the pedestal temperature is increased. The activation energy of the reaction, however, is only 3.8 kcal/mol, indicating that the reaction controlling step is in the gas phase. In order to achieve a commercially acceptable deposition rate for IMD and PMD applications, it is important to maintain the pedestal temperature at about 150°C or above. In another set of experiments and tests, the deposition rate of carbon-doped silicon oxide films was measured for pedestal temperature of 100°C, 150°C and 200°C. In these tests, the 200°C process had a deposition rate of about 1000 Å/min and the 150°C process had a rate of about 500 Å/min. The 100°C process, however, had a rate of about 50 Å/mina rate that is currently considered too low for practical commercial applications as an IMD or PMD layer. At deposition temperatures sufficiently below 100°C ozone may not be activated and deposition may not occur at all.

A technique the inventors have devised to increase the deposition rate at a given pedestal temperature concerns heating at least the upper portion of the substrate processing chamber with the heat exchanger (the temperature controlled liquid that circulates through passages in the chambers walls described in the exemplary chamber section). In most conventional TEOS/ozone IMD deposition applications, the substrate is heated to a temperature of at least 400°C. In a cold wall reactor this heating is done primarily by heating the substrate directly (i.e., with a heated pedestal). At such a relatively high deposition temperature, the effect of the heat exchanger on the deposition process is minimal. That is, the heat exchanger cannot alter process conditions in any significant manner to be thought of as an additional "control knob" for the process.

The present inventors, however, have determined that because of the relatively low substrate temperatures that are preferred for the present invention, the heat exchanger can have a significant effect on deposition rate. Specifically, the heat exchanger can be used as an additional "control knob" to increase the deposition rate of the carbon-doped silicon oxide film. The inventors have determined that heating the glycol/water mixture to a temperature above the normally recommended temperature of 65°C helps activate ozone in the gas phase, which in turn leads to an increased deposition rate for the growing film, a lower dielectric constant and better gap fill properties. Currently preferred embodiments of the invention, use the heat exchanger to heat the glycol/water mixture to between 65 and 100°C.

The inventors have also determined that the gap fill properties of the carbon-doped silicon oxide film deposited according to the present invention are better at lower substrate deposition temperatures as compared with higher deposition temperatures. Figs. 6A-C are sketches showing the cross-sectional view of a film deposited according to the present invention over adjacent raised surfaces. Fig. 6A shows a film deposited at a pedestal temperature of 250°C, while the film in Fig. 6B was deposited at 200°C and the film in Fig. 6C was deposited at 150°C. As shown in the figures, the gap fill capability of the 150°C film is significantly better than the higher temperature films. Higher heat exchanger temperatures, however, improve the gap fill properties of the film. It is believed that these improved properties are due to the effect the heat exchanger has on ozone activation in the gas phase. Increasing the heat exchanger temperature leads to an increase in the gas phase temperature as well as an increase in ozone decomposition in the gas phase reaction.

While the overall deposition pressure can be varied between 1-760 Torr to help obtain desired film properties, it is important that the partial pressure of the organosilane precursor be kept below its vapor pressure in the deposition environment. The formula for partial pressure of the organosilane precursor is set forth as formula (1) below:

$$\text{(Organosilane Flow / Total Gas Flow) x Chamber Pressure} \qquad (1)$$

As evident from the above equation, the flow rate of the organosilane gas is limited by its partial pressure. The flow rate of the organosilane gas has a direct effect on the film deposition rate. It is generally desirable to introduce as much of the organosilane as possible in order to ensure a sufficiently high deposition rate. As would be known to those of skill in the art, the chemical supplier, e.g., a company such as Dow Corning, can provide a list of recommended maximum gas flows at various pressures for organosilane precursors (e.g., TMS) that they supply.

In some embodiments it is preferred that deposition pressure be set above about 100 Torr and below about 450 Torr. Higher pressures generally increase the gas phase reactions of the ozone/organosilane reaction. It is desirable that the gas phase reactions result in a final product (carbon-doped silicon oxide) being formed on the surface of the substrate. If the gas phase reaction is too strong (e.g., at a pressure level about 450 Torr), final product may be formed in the gas phase above the substrate surfaces rather than on the surface. Pressures above 100 Torr are generally desirable to promote good heat transfer between the substrate and pedestal and to achieve good gap fill performance characteristics.

The ozone flow rate also has a strong effect on deposition rate. Flowing more ozone into the chamber allows for more gas phase reactions between the ozone and the organosilane thereby increasing the rate of film deposition. Similarly, flowing a higher concentration of ozone, for example, 12.5 wt. % as opposed to 8 wt. %, also results in an increase in the deposition rate.

Preferred embodiments of the present invention also introduce an inert gas flow, in addition to the organosilane and ozone precursor gas flows, into the chamber during the deposition process. The inert gas flow helps stabilize the deposition process and improves the thickness uniformity of the deposited film. Currently preferred embodiments introduce a flow of helium as the inert gas, but other embodiments can introduce other gases such as argon or nitrogen. The inert gas should not include elements that incorporate into the film in any significant manner.

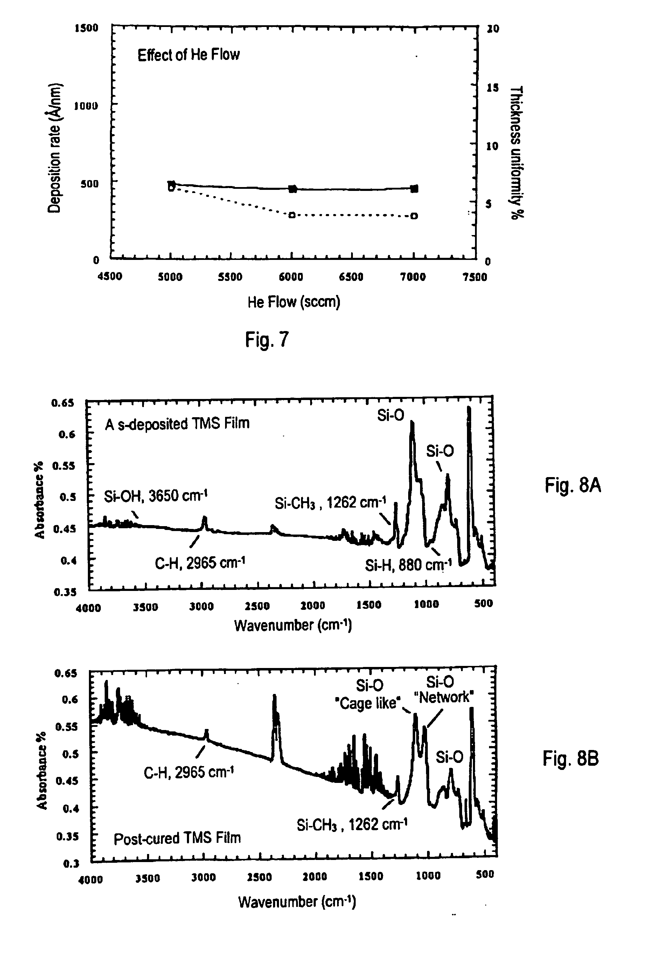

Fig. 7 is a graph showing the effect of an inert gas flow of helium on film uniformity. As evident by Fig. 7, the inventors have determined that a high flow of helium improves film uniformity, but once the flow reaches a certain rate, 6000 sccm for this particular set of deposition conditions, a further increase in the inert gas flow does not further improve film uniformity. The addition of a high flow of helium does not adversely affect other film qualities such as deposition rate or refractive index.

Higher deposition pressure levels generally result in better gap fill properties but lower deposition rate and dielectric constants. Thus, it is important to balance these resulting characteristics depending on the desired physical properties of the deposited film. In one set of experiments, in which the pedestal temperature was set to 200°C, the heat exchanger temperature set to 55° C, spacing was set to 210 mils and a process gas of TMS (500 sccm), helium (6000 sccm) and 12.5 wt. % ozone (4000 sccm) was introduced, pressure was set to 50 Torr and then to 200 Torr. At 50 Torr the film had a deposition rate of 978 Å/min and a k of 2.58. At 200 Torr the film had a deposition rate of 831 Å/min and a k of 2.69. The gap fill properties of the 200 Torr film were improved as compared to the 50 Torr film, however.

The present inventors have found that, subsequent to film deposition, a film cure step (Fig. 3, step 310) can improve film stability, especially if the deposited film is subject to an environment, e.g., the clean room ambient, that contains moisture. Such a cure process forces out moisture already absorbed into the film and changes the film structure so that it is more moisture resistant. The cure process removes undesirable Si-O "cage like" bonds and replaces them with the more desirable Si-O "network" type bonds as would be understood by a person of skill in the art.

Figs. 8A and 8B compare a cured carbon-doped silicon oxide film with uncured film. Fig. 8A shows fourier transform infrared spectrometry (FTIR) data of an as deposited carbon-doped silicon oxide film deposited from TMS, ozone and helium precursor gas mixture. As shown in Fig. 8A, the film contains a relatively high number of Si-O cage-like bonds (wavenumber 1150 cm$^{-1}$) and very few of the desirable Si-O network type bonds. The cage-like bonds have dangling bonds and are susceptible to attracting hydrogen atoms in the presence of moisture such as moisture vapor. As shown in Fig. 8B, once the film is cured, however, many of the Si-O cage-like bonds are converted to the network type bonds resulting in a more stable, highly moisture resistant film. The film deposited for the test shown in Fig. 8A also exhibited a strong stress hysteresis when heated and subsequently cooled and a high dielectric constant (k=5.5) due to moisture absorbtion when exposed to the ambient for a one week period. In contrast, the film deposited and cured for the test in Fig. 8B, exhibited no stress hysteresis when heated and subsequently cooled and retained a low dielectric constant (k=2.9) even when exposed to the ambient for a week.

Several different processes can be performed to effectively cure films deposited according to the present invention. Two process that should not be used, however, include an oxygen plasma cure or a cure in an ozone rich furnace environment. Such processes can result in oxygen atoms reacting with the deposited film and removing the highly desirable Si-C bonds. When this happens the dielectric constant of the film greatly increases and the film becomes unsuitable for applications requiring low dielectric constants.

Instead, the cure process can be performed in a conventional furnace with a relatively inert atmosphere, e.g., nitrogen, or under vacuum conditions. In either case, the cure can be done in situ or ex situ, but ex situ processes are generally preferred since in situ processes require use of a relatively expensive deposition chamber and can significantly reduce throughput of the tool.

In either a conventional furnace or vacuum chamber, the cure process heats the film to a temperature between about 300-500°C for at least about 15 minutes. Higher temperature cures generally take less time than lower temperature ones. For example, a 300°C cure may last for 40-60 minutes while a 500°C cure may last for 15-20 minutes.

In a currently preferred embodiment, a vacuum cure heats the substrate to a temperature of about 400°C for a period of about 30 minutes in a low pressure nitrogen environment. Such a process stabilizes the deposited film so that it resists moisture absorbtion in the future. A currently preferred embodiment of a conventional furnace cure also heats the substrate to a temperature of about 400°C for a period of about 30 minutes. Instead of placing the substrate in a vacuum environment, however, the substrate is placed in a molecular nitrogen ($N_2$) environment at atmospheric pressure. The furnace cure process is preferred to a vacuum cure in some embodiments because it achieves similar or even better film results with less expensive equipment and increased throughput. Throughput is increased because wafers can be transferred into and out of the furnace, which can heat multiple wafers at a time, one at a time as they have finished the curing cycle, e.g., 30 minutes. While a vacuum chamber can also heat and cure multiple wafers at a time, the wafers are loaded and unloaded in batches so as to not break vacuum while the curing process is underway.

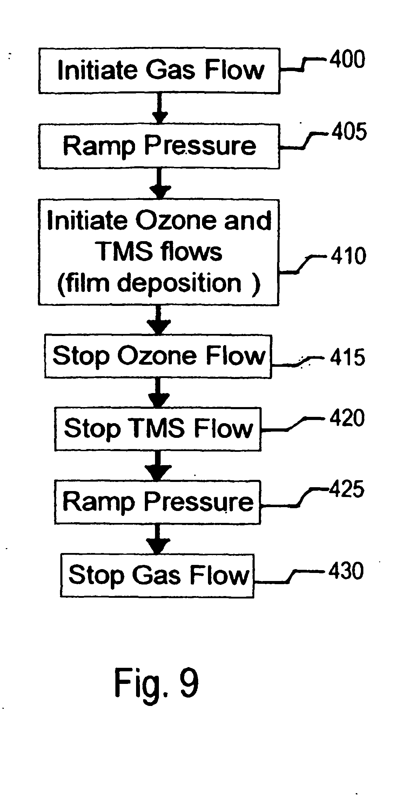

Fig. 9 is a flowchart of a currently preferred process according to the present invention that employs a process gas of TMS, ozone and helium. The process set forth in Fig. 9 is for exemplary purposes only and should not be considered limiting to the scope of the present claims. The deposition process is initiated by, after a wafer has been loaded into the deposition chamber, flowing helium (6000 sccm) and oxygen (4000 sccm) gases while keeping the throttle valve fully open (step 400) for several seconds in order to stabilize the gas flows. Oxygen ($O_2$) is added to the helium flow at the same rate at which ozone is subsequently added. Flowing oxygen in this manner results in a substantially constant oxygen/helium ratio throughout the deposition process. It is believed that maintaining such a constant ratio improves film uniformity. An ozone flow is not introduced at this stage because the high reactivity of ozone.

Once the gas flow has stabilized, the throttle valve is partially closed and the pressure within the chamber is brought to the desired deposition pressure level in the presence of the helium and oxygen flows (step 405). Once the desired pressure level is reached and maintained for a couple of seconds, an ozone flow (4000 sccm) is substituted for the oxygen flow and a flow of TMS is initiated (500 sccm) to deposit a carbon-doped silicon oxide film (step 410). Deposition step 410 is maintained until the carbon-doped silicon oxide layer reaches a desired thickness and then the ozone flow is shut off (step 415). The ozone flow is switched off prior to the TMS flow in order to allow the TMS to react with residual ozone in the gas phase. The present inventors have determined that shutting off the ozone and TMS flows simultaneously can result in ozone reacting with carbon in the deposited film. The TMS flow is then shut off several seconds after the ozone flow (step 420) and the deposition pressure is released by opening the throttle valve while maintaining the helium flow (step 425). Finally, all the gases are shut off (step 430).

The pedestal and heat exchanger temperatures are set and stabilized prior to film deposition. Generally these temperatures are set and unchanged throughout an entire run of multiple wafer depositions.

As described above, the present invention deposits a carbon-doped silicon oxide film that has good gap fill capabilities and a low dielectric constant. The film is also highly conformal. Films deposited according to the present invention are porous when compared to thermal silicon oxide. For example, thermal silicon oxide films generally have a density of between 2.1-2.2 $g/cm^3$. Films deposited according to the present invention, however, generally have a density of less than or equal to about 1.2 $g/cm^3$.

The porousness of the film is provided by very small or micropores as opposed to larger pores found in some porous oxide films. Generally, these micropores are evenly distributed throughout the film and have diameters less than about 100 Å. The present inventors have demonstrated that films deposited according to the present invention exhibit uniform removal rates across the surface of an entire wafer when subject to a CMP step. This is especially important for damascene processes that are used for the fabrication of many integrated circuits today as the surface of the film can become highly planarized after the CMP step allowing for very fine patters to be focused on a subsequently deposited metal layer film during a photolithography step. In one series of tests, films deposited according to the present invention exhibited CMP removal rates of 3687 Å/min. and 3087 Å/min. at a nonuniformity rate of 4 and 5 percent, respectively, as measured at 49 points across the surface of the wafer as would be understood by a person of ordinary skill in the art. These test results compared favorably to removal of a thermal oxide film at a rate of 1100 Å/min at a nonuniformity rate of 3 percent.

The gas flow rates recited and described above are optimized for deposition processes run in a DxZ chamber manufactured by Applied Materials and outfitted for 200 mm wafers. A person of ordinary skill in the art will recognize that the rates at which various precursor gases in the process gas are introduced are in part chamber specific and will vary if chambers of other design and/or volume are employed.

Having fully described several embodiments of the present invention, many other equivalent or alternative methods of depositing the low dielectric constant oxide layer according to the present invention will be apparent to those skilled in the art. These alternatives and equivalents are intended to be included within the scope of the present invention.

**Claims**

1. A method for forming an insulation layer over a substrate disposed in a substrate processing chamber, the method comprising:

   - flowing a process gas comprising ozone and an organosilane having at least one silicon-carbon bond into the substrate processing chamber;
   - heating the substrate to a temperature between 100-250°C to form a carbon-doped silicon oxide layer over the substrate;

   **characterized in that**
   the carbon-doped silicon oxide layer is cured after it is formed over the substrate by heating the substrate to a temperature between 300 and 500°C for at least 15 minutes in an ex situ process.

2. The method of claim 1,
   wherein the carbon-doped silicon oxide layer has a density of less than or equal to about 1.2 $g/cm^3$.

3. The method of claim 1,

wherein the carbon-doped silicon oxide layer has a carbon content of at least about 10 atomic percent.

4.  A method for depositing an intermetal dielectric film over a plurality of conductive lines, the process comprising:

    - flowing a process gas comprising ozone and an organosilane having at least one silicon-carbon bond into the substrate processing chamber;
    - heating the substrate to a temperature of between about 100-250°C to form a carbon-doped silicon oxide layer over the plurality of conductive lines;

    **characterized in that**
    the carbon-doped silicon oxide layer is cured after it is formed over the substrate by heating the substrate to a temperature between 300 and 500°C for at least 15 minutes in an ex situ process.

5.  The method of claim 4,
    wherein a pressure level within the substrate processing chamber is set to between about 100 and 450 Torr.

6.  The method of claim 4,
    wherein the flow of ozone gas is stopped at least 2-3 seconds before the organosilane flow when deposition of said carbon-doped silicon oxide film is substantially complete.

7.  The method of claims 1 or 4,
    wherein the substrate is heated by a pedestal heater set to a temperature between 150-200°C.

8.  The method of claims 1 or 4,
    wherein the organosilane precursor is selected from the group of methylsilane, dimethylsilane, trimethylsilane, tetramethylsilane and phenylmethylsilane.

9.  The method of claims 1 or 4,
    wherein the carbon-doped silicon oxide layer has a dielectric constant less than or equal to 3.0.

10. The method of claims 1 or 4,
    wherein said curing is done in a conventional furnace at atmospheric pressure.

11. The method of claims 1 or 4,
    wherein said curing heats the substrate in a vacuum environment.

12. A substrate processing system comprising:

    - a housing defining a process chamber;
    - a substrate holder, adapted to hold a substrate during substrate processing;
    - a heater, operatively coupled to heat the substrate holder;
    - a gas delivery system configured to introduce gas into the process chamber;
    - a controller for controlling the gas delivery system and the heater; and
    - a memory coupled to the controller comprising a computer-readable medium having a computer-readable program embodied therein which, when carried out, controls any of the methods of claims 1 to 11.


**Patentansprüche**

1.  Ein Verfahren zur Erzeugung einer isolierenden Schicht über einem Substrat, das in einer Substratverarbeitungskammer angeordnet ist, wobei das Verfahren umfasst:

    - Einfließenlassen eines Prozessgases, das Ozon und ein Organosilan umfasst, das wenigstens eine Silizium-Kohlenstoff-Bindung hat, in die Substratverarbeitungskammer;
    - Aufheizen des Substrats auf eine Temperatur zwischen 100 - 250°C, um eine mit Kohlenstoff dotierte Siliziumoxidschicht über dem Substrat zu erzeugen;

    **dadurch gekennzeichnet, dass**

die mit Kohlenstoff dotierte Siliziumoxidschicht, nachdem sie über dem Substrat erzeugt worden ist, durch Aufheizen des Substrats auf eine Temperatur zwischen 300 und 500°C während wenigstens 15 Minuten in einem Ex-Situ-Verfahren ausgeheilt wird.

**2.** Verfahren nach Anspruch 1, worin die mit Kohlenstoff dotierte Siliziumoxidschicht eine Dichte von weniger als oder gleich etwa 1,2 g/cm$^3$ hat.

**3.** Verfahren nach Anspruch 1, worin die mit Kohlenstoff dotierte Siliziumoxidschicht einen Kohlenstoffgehalt von wenigstens etwa 10 Atomprozent hat.

**4.** Ein Verfahren zum Abscheiden einer dielektrischen Zwischenmetall-Schicht über einer Vielzahl von leitfähigen Leitungen, wobei das Verfahren umfasst:

- Einfließenlassen eines Prozessgases, das Ozon und ein Organosilan umfasst, das wenigstens eine Silizium-Kohlenstoff-Bindung hat, in die Substratverarbeitungskammer;
- Aufheizen des Substrats auf eine Temperatur zwischen etwa 100 - 250°C, um eine mit Kohlenstoff dotierte Siliziumoxidschicht über der Vielzahl der leitfähigen Leitungen zu erzeugen;

**dadurch gekennzeichnet, dass**

die mit Kohlenstoff dotierte Siliziumoxidschicht, nachdem sie über dem Substrat erzeugt worden ist, durch Aufheizen des Substrats auf eine Temperatur zwischen 300 und 500°C für wenigstens 15 Minuten in einem Ex-Situ-Verfahren ausgeheilt wird.

**5.** Verfahren nach Anspruch 4, worin ein Druckniveau in der Substratverarbeitungskammer auf zwischen etwa 100 und 450 Torr eingestellt wird.

**6.** Verfahren nach Anspruch 4, worin der Zufluss von Ozongas wenigstens 2 - 3 Sekunden vor dem Organosilan-Zufluss gestoppt wird, wenn die Abscheidung der mit Kohlenstoff dotierten Siliziumoxidschicht im wesentlichen abgeschlossen ist.

**7.** Verfahren nach den Ansprüchen 1 oder 4, worin das Substrat durch eine Podestheizung aufgeheizt wird, die auf eine Temperatur zwischen 150 - 200°C eingestellt ist.

**8.** Verfahren nach den Ansprüchen 1 oder 4, worin das Organosilan-Precursor-Gas ausgewählt wird aus der Gruppe aus Methylsilan, Dimethylsilan, Trimethylsilan, Tetramethylsilan und Phenylmethylsilan.

**9.** Verfahren nach den Ansprüchen 1 oder 4, worin die mit Kohlenstoff dotierte Siliziumoxidschicht eine Dielektrizitätskonstante weniger oder gleich 3,0 hat.

**10.** Verfahren nach den Ansprüchen 1 oder 4, worin das Ausheilen in einem herkömmlichen Ofen bei atmosphärischem Druck ausgeführt wird.

**11.** Verfahren nach den Ansprüchen 1 oder 4, worin das Ausheilen das Substrat in einer Vakuumumgebung aufheizt.

**12.** Ein Substratverarbeitungssystem umfassend:

- ein Gehäuse, das eine Verarbeitungskammer definiert;
- einen Substrathalter, der geeignet ist, ein Substrat während einer Substratverarbeitung zu halten;
- eine Heizung, die wirksam angekoppelt ist, um den Substrathalter aufzuheizen;
- ein Gasabgabesystem, das konfiguriert ist, um Gas in die Verarbeitungskammer einzuführen;
- eine Steuereinrichtung zum Steuern des Gasabgabesystems und der Heizung; und
- ein Speicher, der mit der Steuereinrichtung gekoppelt ist und ein computerlesbares Medium umfasst, das ein computerlesbares Programm darin enthält, das, wenn es ausgeführt wird, eines der Verfahren der Ansprüche 1 bis 11 steuert.

**Revendications**

1.  Procédé de formation d'une couche d'isolation sur un substrat disposé dans une chambre de traitement de substrat, le procédé comprenant:

    - écouler un gaz de traitement comprenant ozone et un organosilane ayant au moins une liaison silicium-carbone dans la chambre de traitement de substrat;
    - chauffer le substrat à une température entre 100 - 250° C pour former une couche en oxyde de silicium dopé au carbone sur le substrat; **caractérisé en ce que** la couche en oxyde de silicium dopé au carbone est traitée après que celle-ci est formée sur le substrat en chauffant le substrat à une température entre 300 et 500° C pour au moins 15 minutes dans un procès ex situ.

2.  Procédé selon la revendication 1, où la couche en oxyde de silicium dopé au carbone présente une densité moins de ou égale à environ 1,2 g/cm$^3$.

3.  Procédé selon la revendication 1, où la couche en oxyde de silicium dopé au carbone présente une teneur en carbone au moins d'environ 10 pour cent atomique.

4.  Procédé pour déposer un film diélectrique intermétal sur une pluralité de lignes conductibles, le procédé comprenant:

    - écouler un gaz de traitement comprenant ozone et un organosilane ayant au moins une liaison silicium-carbone dans la chambre de traitement de substrat;
    - chauffer le substrat à une température entre environ 100 - 250° C pour former une couche en oxyde de silicium dopé au carbone sur la pluralité de lignes conductibles; **caractérisé en ce que** la couche en oxyde de silicium dopé au carbone est traitée après qu'elle est formée sur le substrat en chauffant le substrat à une température entre 300 et 500° C pour au moins 15 minutes dans un procès ex situ.

5.  Procédé selon la revendication 4, où un niveau de pression dans la chambre de traitement de substrat est établi entre environ 100 et 450 Torr.

6.  Procédé selon la revendication 4, où le flux de gaz d'ozone est arrêté au moins 2-3 secondes avant le flux d'organosilane quand le dépôt dudit film en oxyde de silicium dopé au carbone est substantiellement complet.

7.  Procédé selon la revendication 1 ou 4, où le substrat est chauffé par un dispositif de chauffage de piédestal réglé à une température entre 150 - 200° C.

8.  Procédé selon la revendication 1 ou 4, où le précurseur d'organosilane est choisi du groupement de méthylsilane, diméthylsilane, triméthylsilane, tétraméthylsilane et phénylméthylsilane.

9.  Procédé selon la revendication 1 ou 4, où la couche en oxyde de silicium dopé au carbone présente une constante diélectrique moins de ou égale à 3,0.

10. Procédé selon la revendication 1 ou 4, où ledit traitement est fait dans un fourneau conventionnel à la pression atmosphérique.

11. Procédé selon la revendication 1 ou 4, où ledit traitement chauffe le substrat dans un environnement à vide.

12. Un système de traitement de substrat comprenant:

    - un boîtier pour définir une chambre de traitement;
    - un support de substrat pour tenir un substrat pendant le traitement du substrat;
    - un dispositif de chauffage couplé en fonctionnement pour chauffer le support de substrat;
    - un système de délivrance de gaz configuré pour introduire le gaz dans la chambre de traitement;
    - un dispositif de commande pour commander le système de délivrance de gaz et le dispositif de chauffage; et
    - une mémoire couplée au dispositif de commande comprenant un milieu lisible d'ordinateur ayant un programme lisible d'ordinateur incorporé là dedans qui, quand est exécuté commande n'importe lesquels des procédés des revendications 1 à 11.

## FIG 1A

FIG 1B

Controller — 34
37 — Processor   Memory — 38
44
36
RF Power Supply   9
11   Gas Mixing   8
7
40   42
20   17   20
21
10   23
16   14   15   13   19
12b   12   19
19   19
24   26
25
10   15a

EP 1 050 600 B1

FIG 1C

12a
12
26
19
23
26
24
15a

16

FIG 1D

REMOTE SYSTEM
MONITOR AND LIGHTPEN

**FIG 1E**

50a

50b

RS-232 VIDEO
INTERCONNECT PANEL

SYSTEM MONITOR
AND LIGHTPEN

MAIN AC BOX

SYSTEM
MAINFRAME

50a

50b

AC CHANNEL

SYSTEM
ELECTRONICS
RACK

DC POWER
SUPPLY BOX

AC OUTLET
PANEL

## FIG 2

**Processor selector** *-73*
*Chamber selection*
*Process gas flow*
*Temperature*
*Pressure*
*Plasma power*

75

Process sequencer

70

77b

Chamber manager

Chamber manager
for CVD/sputtering chamber

77a

77c

Chamber manager

| Substrate positioning | Process gas control | Pressure control | Heater control | Plasma control |
|---|---|---|---|---|
| 80 | 83 | 85 | 87 | 90 |

Flow ozone and organosilane
precursor into chamber;
Heat substrate to ≤ 250°C to
deposit cabon-doped silicon oxide — 305

Cure deposited film — 310

## Fig. 3

## Fig. 4

Fig. 5

Fig. 6A

Fig. 6B

Fig. 6C

Fig. 7

Fig. 8A

Fig. 8B

```
┌─────────────────────┐
│  Initiate Gas Flow  │╶──⌒─400
└─────────────────────┘
           │
           ▼
┌─────────────────────┐
│    Ramp Pressure    │╶──⌒─405
└─────────────────────┘
           │
           ▼
┌─────────────────────┐
│  Initiate Ozone and │
│      TMS flows      │╶──⌒─410
│  (film deposition ) │
└─────────────────────┘
           │
           ▼
┌─────────────────────┐
│   Stop Ozone Flow   │╶──⌒─415
└─────────────────────┘
           │
           ▼
┌─────────────────────┐
│    Stop TMS Flow    │╶──⌒─420
└─────────────────────┘
           │
           ▼
┌─────────────────────┐
│    Ramp Pressure    │╶──⌒─425
└─────────────────────┘
           │
           ▼
┌─────────────────────┐
│    Stop Gas Flow    │╶──⌒─430
└─────────────────────┘
```

# Fig. 9